# EUROPEAN PATENT SPECIFICATION

(11) **EP 1 429 381 B1**
(45) Date of publication and mention of the grant of the patent: **06.07.2011**
(21) Application number: 03292888.9
(22) Date of filing: 20.11.2003
(51) Int. Cl.: H01L 21/762, H01L 21/20

(54) **A method for manufacturing a material compound**
Verfahren zur Herstellung eines Verbundmaterials
Procédé de fabrication d'un matériau composé

(30) Priority: 10.12.2002 EP 02293049
(43) Date of publication of application: 16.06.2004
(73) Proprietor: S.O.I.Tec Silicon on Insulator Technologies, 38190 Bernin (FR); Commissariat à l'Énergie Atomique et aux Énergies Alternatives, 75015 Paris (FR)
(72) Inventor: Berne, Cecile, c/o SOITEC, 38100 Grenoble (FR); Ghyselen, Bruno, c/o SOITEC, 38170 Seyssinet (FR); Lagahe, Chrystelle, c/o CEA, 38134 St. Joseph de Rivière (FR); Thibaut, Maurice, c/o SOITEC, 38100 Grenoble (FR)
(74) Representative: Grünecker, Kinkeldey, Stockmair & Schwanhäusser Anwaltssozietät

(56) References cited:
- FR-A- 2 767 416
- US-A- 5 877 070
- ASPAR B ET AL: "SMART-CUT TECNOLOGY: AN INDUSTRIAL APPLICATION OF ION IMPLENTATION INDUCED CAVITIES" MATERIALS RESEARCH SOCIETY SYMPOSIUM PROCEEDINGS, MATERIALS RESEARCH SOCIETY, PITTSBURG, PA, US, vol. 510, 13 April 1998 (1998-04-13), pages 381-393, XP000884996 ISSN: 0272-9172
- ASPAR B ET AL: "THE GENERIC NATURE OF THE SMART-CUT PRCESS FOR THIN FILM TRANSFER" JOURNAL OF ELECTRONIC MATERIALS, WARRENDALE, PA, US, vol. 30, no. 7, 22 January 2001 (2001-01-22), pages 834-840, XP001050558

## Description

The present invention relates to a method for manufacturing of a material compound, in particular a heterogeneous or a non-heterogeneous material compound such as a homogeneous material compound like a silicon-on-insulator (SOI)-material, comprising the steps of forming of a predetermined splitting area in a source substrate of a first material; attaching the source substrate to a handle substrate of a second material to form a source-handle-compound; and thermal annealing of the source substrate for a weakening of the source substrate at the predetermined splitting area.

Material compounds such as heterostructures or SOI structures, particularly those consisting of a thin layer of a semiconductor material attached to a handle substrate, have attained considerable industry attention as the next generation of micro-device wafers, especially as used in the fields of microelectronics, optoelectronics or micromechanics.

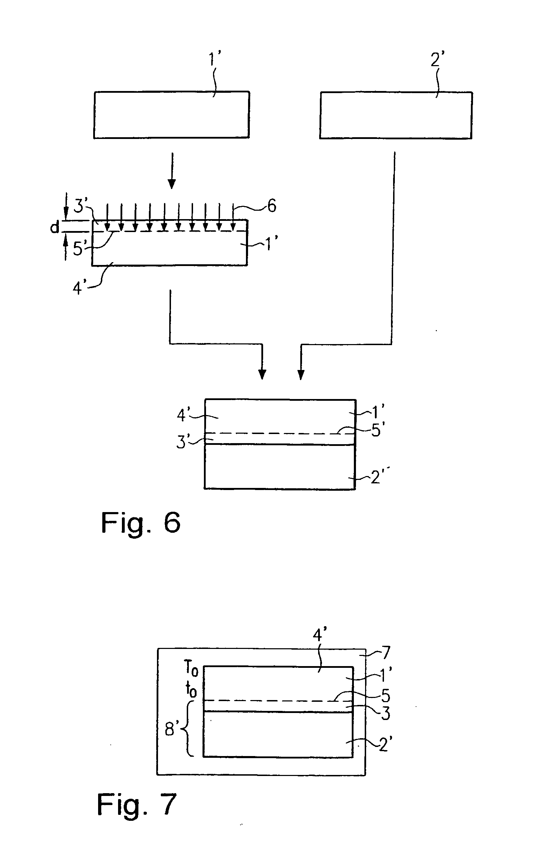

In semiconductor technologies, thin layers are required which are only a few nanometres to a few micrometers thick with a very low thickness variance. Further, there is a major interest in monocrystalline thin layers. A very suitable technique to produce such thin films on a handle substrate is the so called Smart-Cut^{®} process, offering a favourable way to produce for instance SOI (silicon on insulator) wafers with a high quality at low cost. One process flow to obtain SOI wafers using the Smart-Cut^{®} process is shown schematically in figures 6 and 7.

As shown in Fig. 6, two starting wafers, for instance a source or top silicon wafer 1' and a handle or base silicon wafer 2', are provided. An implantation of gaseous species like hydrogen and/or a rare gas like helium is then executed to form a predetermined splitting zone 5' at a certain depth d of the top silicon wafer 1'. Instead of an implantation, any other kind of process can be used which is able to introduce the gaseous species into the wafer 1'.

The predetermined splitting zone defines the location within the top wafer 1' where a split may occur. After implantation, the top wafer 1' is divided in two regions: a thin region 3' whose thickness is determined by the used implantation energy, and the rest 4' of the top wafer 1'.

In the next step, the top wafer 1' is bonded on its implanted surface with the base wafer 2'. Bonding is preferentially achieved by so-called direct wafer bonding based on molecular adhesion; however other bonding techniques such as a method with an intermediate glue layer, anodic bonding or a method with electrostatic treatment assistance can be used instead.

As shown in figure 7, the bonded wafer compound of the wafers 1' and 2' is then heated up in a furnace 7 to supply energy to the bonded wafer compound, especially to the implanted wafer 1' to weaken the bonded wafer. A fracture of the source wafer 1' occurs after applying a certain energy to the wafer compound corresponding to a budget of thermal splitting wherein a thermal budget is a certain quantity of energy fixed by two parameters: annealing time and annealing temperature. The fracture can be initiated not only thermally, but also by any form of additional energy brought to the wafer compound, such as mechanical energy or acoustic energy.

The budget of thermal splitting is a certain thermal budget corresponding to the limit for thermal splitting or cleaving of a material, which is 100% of the necessary energy at which splitting occurs thermally. The used temperature-time-dependency of the budget of thermal splitting follows the Arrhenius Law in which the reciprocal of the annealing time is proportional to the exponent of the reciprocal of the annealing temperature. The budget of thermal splitting of heterogeneous bonded structures is dependent on a number of material, environmental and technological parameters like the kind of material, implantation conditions and bonding conditions.

Then, the rest 4' of the top wafer 1' can be detached resulting in a SOI-structure 8' having the thin monocrystalline silicon layer 3' transferred onto the silicon base wafer 2'.

According to the above example, both the top wafer 1' and the base wafer 2' are of silicon. When bonded and subsequently heated, almost no stress is created in the wafers.

Heterogeneous bonded structures such as SOQ (silicon on fused silica) compounds or other structures cannot be annealed at such high temperatures as silicon-oxide-silicon compounds to split the semiconductor material. The difference between the thermal expansion coefficients of e.g. silicon and fused silica and the different temperature dependencies of the thermal expansion coefficients cause, especially during an annealing step, a high thermal stress in the structure.

In non-implanted bonded heterogeneous wafer compounds this stress leads either to an uncontrolled breakage of at least one of the two wafers and/or to a de-bonding of the wafers. When at least one wafer of the heterogeneous bonded wafer compound is implanted such as in the Smart-Cut^{®} process, there is a sudden variation of stress in the heterogeneous wafer compound after a detachment of a remaining part of the implanted wafer when the detachment occurs at a temperature different from the bonding temperature. This can lead to an indefinite breakage of the wafer compound after such a detachment.

To solve this problem, the temperature of the thermal treatment of the heterogeneous wafer compound can be lowered. However, this lowering must be significant to avoid any indefinite breakage resulting in very long corresponding annealing times in order to achieve the thermal budget necessary for a splitting of the implanted wafer. These times are in the range of several days and are therefore too long to keep an industrial interest.

Another solution for the above problem, which has been presented for instance by Aspar et al in the Proceedings of MRS, 1998, uses a high dose hydrogen implantation to facilitate splitting of a wafer of a heterogeneous wafer compound at the implanted area. However, this high dose ion implantation is an expensive step.

FR-A-2-755-537 describes a method to transfer a thin layer to a heterostructure in which an implanted substrate is thinned down after bonding of this substrate with another substrate to limit a sudden stress variation during splitting of the compound. This method causes an additional process step and results in a significant material consumption because the removed material is lost.

FR-A-2-748-851 discloses a method to detach a structure at lower temperatures using a combination of a heat treatment and mechanical efforts such as traction, shearing or bending forces. Such forces can be applied with a tool, a fluid or with another source of mechanical energy, for instance, as described in EP 0 977 242 A2, with a jet.

US-5-877-070 suggests two specific methods of a Smart-Cut^{®} process to lower a detachment temperature. The first method is based on an additional implantation step using a boron implantation of the wafer to split. This method results in disadvantageous boron doping of the surrounding layers and is, especially due to the additional implantation step, expensive and time-consuming.

The second method which is of the above-mentioned type, uses a pre-anneal before bonding of the wafers. However, the pre-annealing temperature is limited by the effect of blistering of the implanted wafer, resulting in a very fast formation of blisters at the surface of the wafer due to thermal treatment. Blistering occurs quickly with annealing and destroys the flatness of the wafer which is necessary for a sufficient bonding of the wafer. After bonding, a second annealing step is done at a low temperature. Due to the limited thermal budget applied during the pre-annealing step, the second annealing step takes several days to reach the thermal budget to split the implanted wafer.

It is the object of the present invention to provide a method of the above-mentioned type which can be easily carried out with a reduced process time and a very low risk of damage or destruction of the material to get a high quality of the split surface.

This object is solved by a method of the above-mentioned type characterised in that the thermal annealing comprises a first annealing step of the source-handle-compound, wherein the first annealing step is stopped before a splitting of the source substrate; and a second annealing step of the source-handle-compound after the first annealing step, wherein the second annealing step is performed at a lower temperature than the first annealing step.

In the first annealing step, the first material is pre-fragilised thermally but not thermally split yet at said predetermined splitting area. If the second annealing step starts, some thermal energy is already introduced in the first material, and a low temperature is then applied to ease the splitting of the first material at the predetermined splitting area.

Therefore, the second annealing step offers the possibility to apply a thermal energy to the source-handle-compound which helps to split the source substrate at a different thermal energy level than in the first annealing step. The source substrate can be split thermally with a very low risk of an indefinite destruction of the materials of the compound during splitting. An accurate splitting occurs at the predetermined splitting area such as an implanted area.

The thermal splitting avoids a further handling of the source-handle-compound for splitting and therefore reduces the risk of degradation of the substrates that may occur during mechanically assisted splitting, as discussed in FR 2748851 or EP 977242.

The annealing temperature of the first annealing step can be increased to a relatively high value which shortens the annealing time of the second annealing step resulting in a reduced process time.

In an advantageous embodiment of the invention, the second annealing step is performed at least until thermal splitting of the source substrate occurs. The low temperature of the second annealing step leads to a gentle thermal splitting of the source materials.

It is further beneficial to initiate splitting after the second annealing step by providing additional energy. This way, the process time of the second annealing step can be reduced.

In an especially beneficial embodiment, the additional energy is mechanical energy. It has been shown that mechanical energy which is applied after the second annealing step is very effective in providing a final amount of additional energy to split the source-handle-compound.

In a favourable embodiment of the invention, the first annealing step is performed at an energy which is lower than the energy of a budget of thermal splitting at which the source-handle compound can split. This way, in the first annealing step an optimum energy can be applied to the source-handle-compound, which is less than 100% of the budget of thermal splitting of the structure. This prevents an indefinite breakage of the source-handle-compound but induces a thermal energy in the source substrate which is high enough to ease a rapid splitting of the source substrate in or after the second annealing step thereafter.

According to a further embodiment of the invention, the first annealing step is performed at about 70 to 99 % of the temperature-time-ratio of the budget of thermal splitting. This range is particularly suitable to get a reduced process time of the splitting in the second annealing step.

According to a further example of the invention, the source-handle-compound is cooled down between the first annealing step and the second annealing step. Thus, the method can be divided into two different physical steps.

According to a further favourable example of the present invention, the source-handle-compound is cooled to room temperature between the first and the second annealing step, preferably to a temperature between 18°C and 25°C. This temperature requires no further adjustment and allows an easy handling of the wafers between the first and the second annealing step. The temperature between the first and the second annealing step can be below the temperature of the second annealing step.

According to a further favourable variant of the invention, the source-handle-compound is cooled to a temperature of the second annealing step between the first and the second annealing step. This facilitates a change from the first annealing step to the second annealing step and reduces the process time. For example, the temperature can be directly cooled down from the first step temperature level to the second step temperature level.

In another advantageous embodiment of the invention, the first annealing step and/or the second annealing step comprises a step-wise reduction of the annealing temperature. This makes it possible to reduce the annealing time, resulting in increased productivity of the splitting process.

In a yet further preferable embodiment of the invention, the first material and/or the second material is at least one of a group of materials consisting of silicon, an A(III)-B(V)-semiconductor, an alloy of an A(III)-B(V)-semiconductor, SiGe, silicon carbide, synthetic quartz and fused silica. With these materials, heterogeneous material compounds can be manufactured which cover most of the presently required heterostructures, for instance in microelectronics, in optoelectronics or in micromechanics. It also covers non-heterogeneous material compounds like SOI.

According to a yet further advantageous variant of the invention, the source substrate is a silicon wafer and said handle substrate is a synthetic quartz wafer. By this method so-called SOQ (silicon-on-fused silica) wafers can be produced.

Specific embodiments of the present invention shall become more apparent from the following detailed description with reference to the accompanying drawings, in which:
Figure 1 schematically shows a first annealing step of a method according to a first embodiment of the present invention;
Figure 2 schematically shows a second annealing step of a method according to the first embodiment of the present invention;
Figure 3 shows a temperature-time diagram showing illustratively the temperature-time course during a method according to the first embodiment of the present invention;
Figure 4 shows a temperature-time diagram showing illustratively the temperature-time course during a method according to a second embodiment of the present invention;
Figure 5 shows a temperature-time diagram showing illustratively the temperature-time course during a method according to a third embodiment of the present invention;
Figure 6 schematically shows the process preparation steps of a conventional Smart Cut® process, including oxidation, implantation and wafer bonding; and
Figure 7 schematically shows an illustrative arrangement of an annealing step used in the conventional Smart Cut® process of Figure 6.

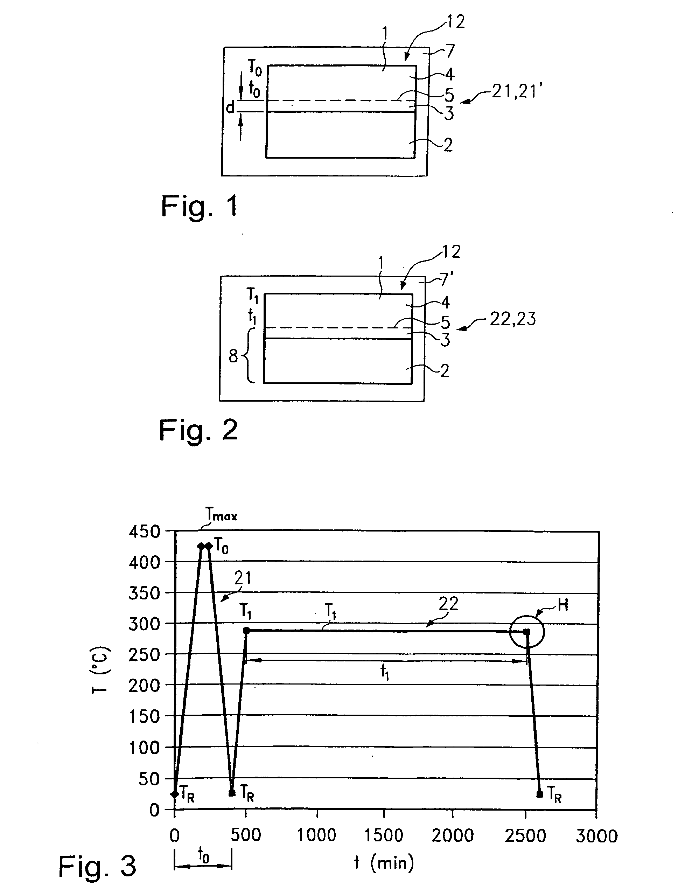

In Figures 1 to 5 the same reference signs as in Figures 6 to 7 are used to denote similar or equal components and parts.

Figure 1 schematically shows a first annealing step of a method according to a first embodiment of the present invention. There, a wafer compound 12 consisting of a first wafer 1 and a second wafer 2 which are bonded in a furnace 7. The furnace 7 is heated up to an annealing temperature T₀ for an annealing time to. The first wafer 1 is a source wafer made of silicon while the second wafer 2 is a handle wafer made of fused silica. In another embodiment of the invention, wafers 1 and 2 can be of any other semiconductor, conductor or insulator material used in microelectronics or a similar technical field, such as an A(III)-B(V)-semiconductor like GaAs, InP or GaN, an alloy of an A(III)-B(V)-semiconductor, SiGe, silicon carbide, synthetic quartz and fused silica. Preferably, the first wafer 1 and the second wafer 2 are of different materials, but these wafers 1, 2 can also be of the same material.

Wafer 1 is implanted with hydrogen and/or helium ions forming a buried, predetermined splitting area 5 in a depth d of wafer 1. The area 5 which is shown in figure 1 from the front side as a line can also be produced by an implantation of other ions like boron or phosphor or by a combination of these ions with hydrogen ions. The ions can also be buried in wafer 1, for instance during wafer manufacturing. The area 5 can also be pre-weakened by a local distortion of the crystallinity of the wafer 1, induced for instance by a radiation or mechanical influence.

Figure 2 schematically shows a second annealing step 22 of a method according to a first embodiment of the present invention where the wafer compound 12 is placed in another furnace 7' heated up to an annealing a temperature T₁ for an annealing time t₁ at least until splitting of the wafer 1 at the pre-fragilised buried splitting area 5. Optionally, to employ the second annealing step, the wafer compound can be left in the first furnace 7.

The resulting structure 8 comprises a thin monocrystalline silicon layer 3 which is attached to the handle wafer 2. The rest 4 of the wafer 1 can be removed from the structure 8 as one piece.

Figures 3 to 5 show temperature-time-diagrams showing illustratively the temperature-time-course during methods according to first, second and third embodiments of the present invention. In the embodiments the following process conditions are used:

| | |
|---|---|
| Source substrate: | silicon |
| Handle substrate: | fused silica or silicon |
| Thickness of buried oxide: | about 50 nm to about 1000 nm |
| Energy of implantation: | about 30 keV to about 200 keV |
| Dose of implantation: | about 1x10¹⁶ cm⁻² to about 1x10¹⁷ cm⁻² |
| Process window of the first annealing step: | between about 350°C to about |
| | 500°C, for about some minutes to |
| | about a few hours |
| Process window of the second annealing step: | between about 150°C to about |
| | 350°C. for about a few hours to about |
| | a few days |

Figure 3 shows a temperature-time diagram showing illustratively the temperature-time course during a method according to a first embodiment of the present invention in which the temperature is held for a period of time in a second annealing step.

As shown in Figure 3, in the first annealing step 21, the wafer compound 12 is introduced into the furnace 7 at a room temperature T_{R}. Room temperature T_{R} corresponds to a temperature value between 18° and 25°C. Then, the temperature is continuously heated up to the annealing temperature T₀, which is, in the example shown, about 425°C. Then, the temperature is held at the level of T₀ for several minutes. Alternatively, the temperature can be held for a longer period of time, such as several hours. Thereafter, the temperature is continuously cooled down to room temperature T_{R}.

In another embodiment of the invention, the wafer compound 12 can be introduced in the furnace 7 at different temperatures. The temperature of the furnace 7 can be modified in accordance with the type of furnace and the implantation conditions.

The energy applied to the heterogeneous bonded wafer compound 12 in the first annealing step 21 corresponds to about 90% of the splitting thermal budget of the wafer compound 12 at which a splitting of the source-handle-wafer-compound 12 may occur. The first annealing step 21 causes a fragilisation at the predetermined splitting area, but without splitting of the wafer 1 or of wafer 2 and without de-bonding of the wafer-compound 12.

In a second annealing step 22, the wafer compound 12 is heated up to a temperature T₁ and is then held at this temperature for a longer period of time t1, for example about 1800 minutes. At an annealing time and an annealing temperature which is marked by the arrow H, the wafer compound splits thermally. Thereafter, the split wafer parts are cooled down to room temperature T_{R}.

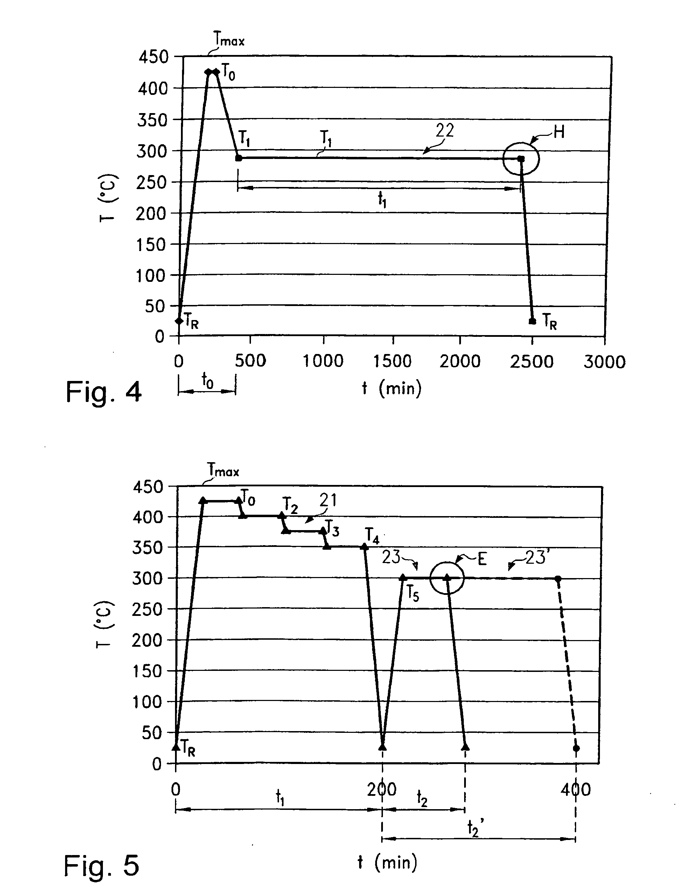

Figure 4 shows a temperature-time diagram showing illustratively the temperature-time course during a method according to a second embodiment of the present invention in which the temperature is cooled after a first annealing step 21' directly to a temperature T₁ of the second annealing step 22.

Figure 5 shows a temperature-time diagram showing illustratively the temperature-time course during a method according to a third embodiment of the present invention in which the temperature is step-wisely reduced during the first annealing step.

In the third embodiment of the invention, the wafer compound 12 is heated up in the first annealing step 21 from room temperature T_{R} to a value T₀, is further held on this temperature T₀ of about 425°C for several minutes and is then cooled over several temperature steps T₂,T₃,T₄ down to room temperature T_{R}. In the example shown, the wafer compound 12 is first cooled to a temperature T₂ which is about 20° to 30° lower than temperature T₀. At this temperature T₂ the wafer compound 12 is held for a couple of minutes. Thereafter, the wafer compound 12 is cooled down to a temperature T₃ which is an additional 20° to 30° lower than temperature T₂. After a few minutes, the wafer compound is further continuously cooled down to a temperature T₄ of about 350°C where it is held for several minutes and is then cooled down to room temperature T_{R}.

The energy applied to the wafer compound 12 during the first annealing step 21 corresponds to about 90% of the budget of thermal splitting of the wafer compound 12.

In the second annealing step 23, which follows the first annealing step 21, the wafer compound 12 is heated up from room temperature T_{R} to a temperature T₅ of about 300°C where it is held for about 60 to 80 minutes until splitting occurs. The energy applied to the wafer compound in the second annealing step 23 corresponds to about 10% of the budget of thermal splitting. The splitting point is marked with the arrow E.

In another embodiment of the invention (not shown), the second annealing step 23 can be stopped before splitting occurs. Then, an additional amount of energy is applied to the wafer compound 12. The additional energy may be provided in any form, such as mechanical energy, radiation or acoustic energy, which leads to splitting of the wafer compound 12.

After splitting, the structure 8 and the rest 4 of the source wafer 1 are cooled down to room temperature T_{R}.

As indicated by 23', in another embodiment of the invention, the wafer compound 12 can be held longer than 80 minutes at the temperature T₅, even up to 160 to 200 minutes.

In the third embodiment according to Fig. 5, the subsequent steps in which the temperature is stepwise reduced enable a reduction of the duration of the last step where the thermal splitting occurs. This variant is an optimisation of the pre-fragilisation step. It can be applied to the first and/or the second annealing step 21, 23.

In the following, the function and the effect of the embodiments shown are explained.

With reference to Figure 3, in the first annealing step 21, a relatively high temperature T₀ is applied for a relatively short time. The effect of the used annealing temperature and annealing time corresponds to about 90% of the thermal budget of the bonded wafer compound.

At a thermal budget T₀, t₀ an initial thermal energy can be applied to the wafer compound, forming a pre-fragilisation of the pre-determined buried splitting area in the source wafer 1 of the wafer compound which is the basis for a later splitting phenomenon. The second annealing step 22 is performed after the first one and at a much lower temperature than that used during the first annealing step 21. The optimisation of pre-fragilisation can occur not only in the first annealing step but also in the second step.

As shown in Figure 3, the temperature of the first annealing step 21 is about 400°C to 450°C whereas the temperature of the second annealing step 22 is below 400°C. The induced thermal energy during the second annealing step helps to split the wafer compound into two wafer parts along the predetermined splitting area 5. This results in a SOQ wafer 8 consisting of the quartz substrate 2 and a thin silicon layer 3 thereon or in a SOI wafer consisting of a silicon substrate and a thin silicon layer thereon.

With reference to Figure 4, where nearly the same annealing temperatures and annealing times are used as in the first embodiment shown in Figure 3, the temperature between the first annealing step 21' and the second annealing step 22 is cooled down to the temperature T₁ of the second annealing step 22. The annealing steps 21', 22 are performed in the same furnace 7. This shortens the transition time from the first annealing step 21' to the second annealing step 22 and reduces therefore the entire process time.

As shown in Figure 5, the annealing time of the second annealing step 23 can be shortened by a rapid heating up of the wafer compound 12 in the first annealing step 21 to a temperature T₀ of about 425°C, and a step-wise reduction of the temperature at certain temperature levels T₂, T₃, T₄. The thermal energy applied to the structure of the wafer compound 12 in the two annealing steps 21, 23 corresponds to 100% of the budget of thermal splitting of the wafer compound 12, so that after a certain period of time at the temperature T₅ of the second annealing step 23 a thermal splitting of the wafer compound at the area 5 can be achieved.

The stepwise reduction of the temperature in the first annealing step 21 also can lead to a pre-fragilisation so that an easier splitting in the second annealing step 23 is attained. Instead of the temperature profile shown in Figure 5, any other favourable temperature profile can be used for splitting of the wafer compound 12.

Moreover, it is possible to change the temperature in the first annealing step 21 so that the temperature between the temperature steps T₀, T₂, T₃, or T₄ rises. For instance, the temperature can be reduced from T₀ over T₂ to T₃ and can be further enhanced to T₂ and then again reduced to T₃ and to T_{R}.

Furthermore, it is possible to combine the first and the second annealing step into one annealing step in which the temperature between the two annealing steps is not reduced to room temperature T_{R}.

It should be further taken into consideration that the above-mentioned annealing times and annealing temperatures are favourably related to splitting of wafer compounds consisting of silicon and fused silica with conventional thicknesses, warps and thermal features. When other substrates with other features or different implantation conditions are used, it should be considered that the given times and temperatures are to be adapted accordingly.

## Claims

1. A method for manufacturing of a material compound (8), comprising the steps of:
forming of a predetermined splitting area (5) in a source substrate (1) of a first material;
attaching the source substrate (1) to a handle substrate (2) of a second material to form a source-handle-compound (12); and
thermal annealing of the source substrate (1) for a weakening of the source substrate (1) at the predetermined splitting area (5),
**characterised in that**
the thermal annealing comprises:
a first annealing step (21, 21') of the source-handle-compound (12), wherein the first annealing step (21, 21') is stopped before a splitting of the source substrate (1); and
a second annealing step (22, 23, 23') of the source-handle-compound (12) after the first annealing step (21, 21'), wherein the second annealing step (22, 23, 23') is performed at a lower temperature than the first annealing step (21, 21').

2. The method of claim 1, **characterised in that** the second annealing step is performed at least until thermal splitting of the source substrate (1).

3. The method of at least one of the preceding claims, **characterised in that** the splitting is initiated after the second annealing step, by providing additional energy.

4. The method of claim 3, **characterised in that** the additional energy is mechanical energy.

5. The method of at least one of the preceding claims, **characterised in that** the first annealing step (21, 21') is performed at an energy which is lower than the energy of a budget of thermal splitting at which the source-handle-compound (12) can split.

6. The method of claim 5, **characterised in that** the first annealing step (21, 21') is performed at 70 to 99 % of the energy of the budget of thermal splitting.

7. The method of at least one of the preceding claims, **characterised in that** the source-handle-compound (12) is cooled down between the first annealing step (21, 21') and the second annealing step (22, 23, 23').

8. The method of claim 7, **characterised in that** the source-handle-compound is cooled to room temperature (TR).

9. The method of claim 8, wherein the source handle compound is cooled to a temperature between 18°C and 25°C.

10. The method of claim 7, **characterised in that** the source-handle-compound is cooled to a temperature of the second annealing step (22, 23, 23').

11. The method of at least one of the preceding claims, **characterised in that** the first annealing step (21, 21') and/or the second annealing step (22, 23, 23') comprises a step-wise reduction of the annealing temperature.

12. The method of at least one of the preceding claims, **characterised in that** said first material and/or said second material is at least one of a group of materials consisting of silicon, an A(III)-B(V)-semiconductor, an alloy of an A(III)-B(V)-semiconductor, SiGe, silicon carbide, synthetic quartz and fused silica.

13. The method of at least one of the preceding claims, **characterised in that** said source substrate (1) is a silicon wafer and said handle substrate (2) is a wafer consisting of fused silica or a synthetic quartz.

14. The method of at least one of the preceding claims, wherein the step of forming of a predetermined splitting area comprises implanting hydrogen and/or helium ions in the source substrate (1)

15. The method according to one of claims 1 to 14, wherein the material compound is a heterogeneous or a non-heterogeneous material compound like a silicon-on-insulator material.

## Patentansprüche

1. Verfahren zum Herstellen eines Verbundmaterials (8), das die folgenden Schritte umfasst:
Ausbilden eines vorgegebenen Abtrennbereiches (5) in einem Source-Substrat (1) aus einem ersten Material;
Anbringen des Source-Substrats (1) an einem Halter-Substrat (handle substrate) (2) aus einem zweiten Material, um einen Source-Halter-Verbundkörper (12) auszubilden; und
Wärmebehandeln des Source-Substrats (1) zum Abschwächen des Source-Substrats (1) an dem vorgegebenen Abtrennbereich (5), **dadurch gekennzeichnet, dass** das Wärmebehandeln umfasst:
einen ersten Schritt (21, 21') der Wärmebehandlung des Source-Halter-Verbundkörpers (12), wobei der erste Wärmebehandlungsschritt (21, 21') vor einem Abtrennen des Source-Substrats (1) angehalten wird; und
einen zweiten Schritt (22, 23, 23') der Wärmebehandlung des Source-Halter-Verbundkörpers (12) nach dem ersten Wärmebehandlungsschritt (21, 21'), wobei der zweite Wärmebehandlungsschritt (22, 23, 23') bei einer niedrigeren Temperatur durchgeführt wird als der erste Wärmebehandlungsschritt (21, 21').

2. Verfahren nach Anspruch 1, **dadurch gekennzeichnet, dass** der Wärmebehandlungsschritt wenigstens bis zum thermischen Abtrennen des Source-Substrats (1) durchgeführt wird.

3. Verfahren nach wenigstens einem der vorgehenden Ansprüche, **dadurch gekennzeichnet, dass** das Abtrennen nach dem zweiten Wärmebehandlungsschritt durch Zuführen zusätzlicher Energie eingeleitet wird.

4. Verfahren nach Anspruch 3, **dadurch gekennzeichnet, dass** die zusätzliche Energie mechanische Energie ist.

5. Verfahren nach wenigstens einem der vorangehenden Ansprüche, **dadurch gekennzeichnet, dass** der Wärmebehandlungsschritt (21, 21') bei einer Energie durchgeführt wird, die niedriger ist als die Energie eines Budgets für thermisches Abtrennen, bei dem der Source-Halter-Verbundkörper (12) getrennt werden kann.

6. Verfahren nach Anspruch 5, **dadurch gekennzeichnet, dass** der erste Wärmebehandlungsschritt (21, 21') bei 70 bis 99 % der Energie des Budgets zum thermischen Abtrennen durchgeführt wird.

7. Verfahren nach wenigstens einem der vorangehenden Ansprüche, **dadurch gekennzeichnet, dass** der Source-Halter-Verbundkörper (12) zwischen dem ersten Wärmebehandlungsschritt (21, 21') und dem zweiten Wärmebehandlungsschritt (22, 23, 23') abgekühlt wird.

8. Verfahren nach Anspruch 7, **dadurch gekennzeichnet, dass** der Source-Handle-Verbundkörper auf Raumtemperatur (TR) abgekühlt wird.

9. Verfahren nach Anspruch 8, wobei der Source-Halter-Verbundkörper auf eine Temperatur zwischen 18°C und 25°C abgekühlt wird.

10. Verfahren nach Anspruch 7, **dadurch gekennzeichnet, dass** der Source-Halter-Verbundkörper auf eine Temperatur des zweiten Wärmebehandlungsschritts (22, 23, 23') abgekühlt wird.

11. Verfahren nach wenigstens einem der vorangehenden Ansprüche, **dadurch gekennzeichnet, dass** der erste Wärmebehandlungsschritt (21, 21') und/oder der zweite Wärmebehandlungsschritt (22, 23, 23') eine schrittweise Reduzierung der Wärmebehandlungstemperatur umfassen/umfasst.

12. Verfahren nach wenigstens einem der vorangehenden Ansprüche, **dadurch gekennzeichnet, dass** das erste Material und/oder das zweite Material wenigstens aus einem einer Gruppe von Materialien bestehen/besteht, die sich aus Silizium, einem A(III)-B(V)-Halbleiter, einer Legierung aus einem A(III)-B(V)-Halbleiter, SiGe, Siliziumkarbid, synthetischem Quarz und Quarzglas zusammensetzt.

13. Verfahren nach wenigstens einem der vorangehenden Ansprüche, **dadurch gekennzeichnet, dass** das Source-Substrat ein Silizium-Wafer ist und das Halter-Substrat (2) ein Wafer ist, der aus Quarzglas oder einem synthetischem Harz besteht.

14. Verfahren nach wenigstens einem der vorangehenden Ansprüche, wobei der Schritt des Ausbildens eines vorgegebenen Abtrennbereiches Implantieren von Wasserstoff- und/oder Helium-lonen in das Source-Substrat (1) umfasst.

15. Verfahren nach einem der Ansprüche 1 bis 14, wobei das Verbundmaterial ein heterogenes oder nicht heterogenes Verbundmaterial, wie beispielsweise Silicon-on-Insulator-Material, ist.

## Revendications

1. Procédé de fabrication d'un matériau composite (8) comprenant les étapes de :
formation d'une zone de séparation prédéterminée (5) dans un substrat source (1) d'un premier matériau ;
fixation du substrat source (1) à un substrat de manipulation (2) d'un second matériau, de façon à former un composite source-de manipulation (12) ; et
recuit thermique du substrat source (1) pour affaiblir le substrat source (1) au niveau de la zone de séparation prédéterminée (5),
**caractérisé en ce que**
le recuit thermique comprend :
une première étape de recuit (21, 21') du composite source-de manipulation (12), où la première étape de recuit (21, 21') est interrompue avant la séparation du substrat source (1) ; et
une seconde étape de recuit (22, 23, 23') du composite source-de manipulation (12) après la première étape de recuit (21, 21') où la seconde étape de recuit (22, 23, 23') est exécutée à une température inférieure à celle de la première étape de recuit (21, 21').

2. Procédé selon la revendication 1, **caractérisé en ce que** la seconde étape de recuit est exécutée au moins jusqu'à séparation thermique du substrat source (1).

3. Procédé selon au moins une des revendications précédentes, **caractérisé en ce que** la séparation est initialisée après la seconde étape de recuit, en fournissant une énergie supplémentaire.

4. Procédé selon la revendication 3, **caractérisé en ce que** l'énergie supplémentaire est de l'énergie mécanique.

5. Procédé selon au moins une des revendications précédentes, **caractérisé en ce que** la première étape de recuit (21, 21') est exécutée avec une énergie inférieure à l'énergie du bilan de séparation thermique à laquelle le composite source-de manipulation (12) peut se séparer.

6. Procédé selon la revendication 5, **caractérisé en ce que** la première étape de recuit (21, 21') est exécutée à 70 % jusqu'à 99 % de l'énergie du bilan de séparation thermique.

7. Procédé selon au moins une des revendications précédentes, **caractérisé en ce que** le composite source-de manipulation (12) est refroidi entre la première étape de recuit (21, 21') et la seconde étape de recuit (22, 23, 23').

8. Procédé selon la revendication 7, **caractérisé en ce que** le composite source-de manipulation est refroidi jusqu'à la température ambiante (TR).

9. Procédé selon la revendication 8, dans lequel le composite source-de manipulation est refroidi jusqu'à une température comprise entre 18°C et 25°C.

10. Procédé selon la revendication 7, **caractérisé en ce que** le composite source-de manipulation est refroidi jusqu'à la température de la seconde étape de recuit (22, 23, 23').

11. Procédé selon au moins une des revendications précédentes, **caractérisé en ce que** la première étape de recuit (21, 21') et/ou la seconde étape de recuit (22, 23, 23') comprennent une réduction progressive de la température de recuit.

12. Procédé selon au moins une des revendications précédentes, **caractérisé en ce que** ledit premier matériau et/ou ledit second matériau sont un matériau appartenant un groupe de matériaux constitués du silicium, d'un semiconducteur A(III)-B(V), d'un alliage de semiconducteur A(III)-B(V), de SiGe, de carbure de silicium, de quartz synthétique et de silice fondue.

13. Procédé selon au moins une des revendications précédentes, **caractérisé en ce que** ledit substrat source (1) est une plaquette de silicium et ledit substrat de manipulation (2) est une plaquette constituée de silice fondue ou de quartz synthétique.

14. Procédé selon au moins une des revendications précédentes, dans lequel l'étape de formation d'une zone de séparation prédéterminée comprend l'implantation d'ions d'hydrogène et/ou d'hélium dans le substrat source (1).

15. Procédé selon l'une des revendications 1 à 14, dans lequel le matériau composite est un matériau composite hétérogène ou non hétérogène tel qu'un matériau de silicium sur isolant.
